# EUROPEAN PATENT SPECIFICATION

(11) **EP 2 536 027 B1**
(45) Date of publication and mention of the grant of the patent: **20.05.2015**
(21) Application number: 12171441.4
(22) Date of filing: 11.06.2012
(51) Int. Cl.: H03G 3/20, H04N 5/52

(54) **Method and device for equalizing a plurality of radio-television channels**
Verfahren und Vorrichtung zum Entzerren von mehreren Rundfunk- und Fernseh-Kanälen
Procédé et dispositif pour équalizer une pluralité de canaux radio et télévision

(30) Priority: 13.06.2011 IT TO20110521
(43) Date of publication of application: 19.12.2012
(73) Proprietor: Fracarro Radioindustrie S.p.A., 31033 Castelfranco Veneto (TV) (IT)
(72) Inventor: Beghetto, Roberto, 35019 Tombolo (PD) (IT); Xillo, Daniele, 31031 Caerano di San Marco (TV) (IT)
(74) Representative: Camolese, Marco

(56) References cited:
- US-A1- 2005 032 495
- US-A1- 2009 086 107
- US-B1- 7 088 975

## Description

The present invention relates to a method and a device for equalizing a plurality of radio-television channels.

In a radio-television signal distribution network, it is usually required that the television channels, or transponders, that must be distributed be equalized. This requirement is due to the fact that radio-television signal receivers are designed in a manner such that input signals must have levels within a certain range. When such levels are inhomogeneous, there is a risk that the receiver might not receive the weakest signals, and that the strongest signals might be distorted by the receiver itself as they are being processed.

In a radio-television signal receiver, therefore, the amplifiers' function is critical, in that they must amplify the received channels while at the same time ensuring good signal quality.

Among the parameters that characterize an amplifier, the most important ones are normally gain, distortion and noise figure.

Gain is the ratio between the amplitudes of the output and input signals.

Distortion indicates the capability of an apparatus to reproduce the input signal at its output, without introducing any elements caused by non-linearity of the apparatus itself. Non-linearity occurs when frequency multiples (harmonics) of the signal appear, if the input is a sinusoidal signal.

Of course, the less the distortion introduced by an amplifier, the better the apparatus.

The capability of an amplifier to output an undistorted signal depends on the characteristics of the active element that performs amplification. Said element is characterized by the maximum signal it can output with distortion under a specified limit.

For a given apparatus, the higher the output signal, the greater the distortion thereof.

As a consequence, once an apparatus and an input signal have been defined, increasing gain will adversely affect the possibility of having an undistorted signal.

Very often the input is not just constituted by one signal, but by a plurality of signals.

In such a case, the increased number of signals will imply a reduction in the level available for each of them, since the power that the apparatus can output is defined by a characteristic value thereof.

For example, in the case of television signals, doubling the number of transponders will imply halving the output power of each of them.

The noise figure is an index indicating the extent to which the apparatus introduces noise mainly due to thermal noise that mostly affects low-level input signals.

In this case as well, the smaller the noise figure, the better the characteristics of the apparatus in this aspect.

Document US 7,088,975 describes a receiver comprising a first Variable Gain Amplifier (VGA) that amplifies an input signal in accordance with a first gain to produce a first amplified signal. The first gain is controlled based on the first amplified signal. The receiver includes a second VGA that produces a second amplified signal responsive to the first amplified signal. The second VGA has a second gain controlled based on the second amplified signal.

It is therefore one object of the present invention to provide a method and a device for equalizing a plurality of radio-television channels by amplifying them to the highest possible signal level without generating any signal distortion.

It is a further object of the present invention to provide a method and a device for equalizing a plurality of radio-television channels which can be easily implemented from a circuital viewpoint.

In short, the device of the present invention comprises subdivision means for subdividing a plurality of radio-television channels into channel groups, wherein each channel group comprises one or more radio-television channels. The groups are composed in a manner such that each channel belongs to one sole channel group.

Each channel group is then autonomously filtered and amplified, so that all channels have substantially the same signal level.

Upstream and downstream of the subdivision means there are, respectively, an input amplifier and an output amplifier, the gains of which are adjusted in a manner such that the radio-television channels outputted by the device have the highest possible signal level without any distortion.

Said objects are achieved through the method and the device for equalizing a plurality of radio-television channels having the features set out in the appended claims, which are intended to be an integral part of the present description.

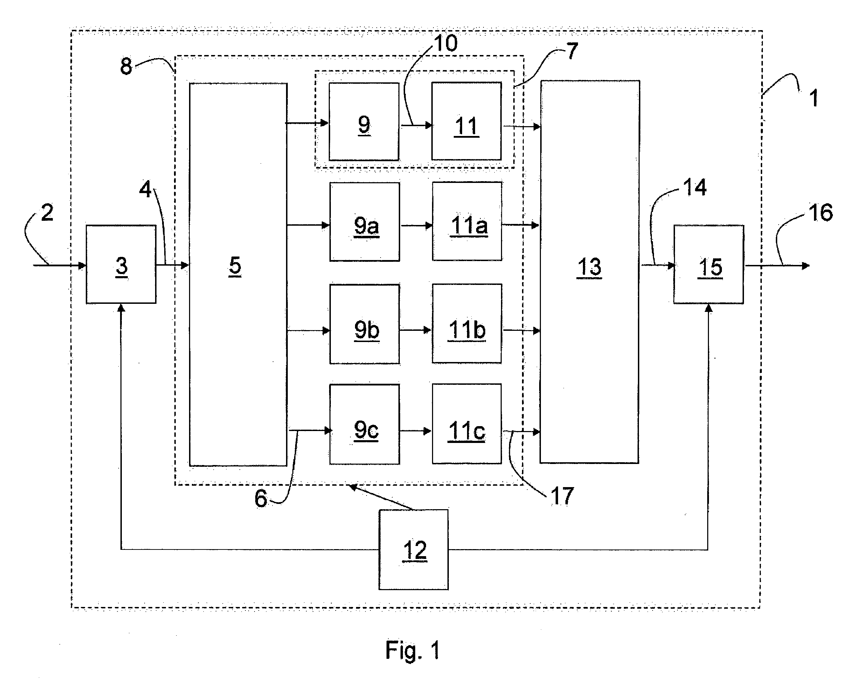

The invention will now be described in detail in some of its preferred embodiments, which are provided by way of non-limiting example with reference to the single annexed Figure 1, which shows a block diagram of a device for equalizing a plurality of radio-television channels according to the present invention.

With reference to Figure 1, there is shown a block diagram of a device 1 for equalizing a plurality of radio-television channels 2, which comprises:
- an input variable-gain amplifier 3 for amplifying the plurality of radio-television channels 2;
- subdivision means 8, arranged downstream of said input amplifier 3, for subdividing the plurality of radio-television channels 2 into channel groups, wherein the subdivision means 8 comprise a distribution matrix 5 for replicating the plurality of radio-television channels 2 at the inputs of filtering and amplifying means 7, or cells;
- an adder 13, in particular a sum matrix, arranged downstream of the subdivision means 8 and adapted to add up the channels 17 outputted by the subdivision means 8;
- an output variable-gain amplifier 15, arranged upstream of the adder 13.

The radio-television channels 2 comprise a plurality of radio-television channels in the UHF band, in particular a plurality of digital terrestrial radio-television channels, more in particular the channels 21-69 of the UHF band.

The plurality of radio-television channels 2 enter the input amplifier 3, where they are amplified.

The channels 4 outputted by the input amplifier 3 are presented to the distribution matrix 5, which supplies the channels 4 to the inputs of the cells 7.

The subdivision means 8 first subdivide the channels 4 into channel groups 10, in a manner such that each channel group 10 includes at least one channel and each channel is only present in one channel group 10.

To carry out this task, the subdivision means 8 comprise a plurality of cells 7, which in turn comprise a frequency-variable and bandwidth-variable filter 9 and an intermediate variable-gain amplifier 11.

Let us assume, for example, that a cell 7a receives the channels 21-69 of the UHF band. The frequency-variable and bandwidth-variable filter 9a will select and allow to pass through, for example, only the channels 21 and 22.

Likewise, the filter 9b of the cell 7b will select and allow to pass through, for example, only the channels 32,33,34,35,36, whereas the filter 9c of the cell 7c will select and allow to pass through, for example, only the channels 53,54,55 and 56.

Typically each channel group 6 comprises one to six channels, or transponders, and preferably the device 1 places into the same group channels with very similar levels, in particular it places into the same group adjacent channels, such as the channels 21-22 of the cell 7a, the channels 32-36 of the cell 7b, and the channels 53-56 of the cell 7c. Subsequently, the subdivision means 8 amplify the channels of each channel group 10, through the intermediate amplifiers 11, in a homogeneous manner according to the following procedure:
- the input amplifier 3 and the output amplifier 15 are adjusted to respective maximum gain values, which are known because they have been stored into memory means of the device 1 during a testing stage carried out by the manufacturer on the device itself;
- only one cell 7 is powered in rotation;
- the variable-frequency and variable-bandwidth filter 9 of the cell 7 only is adjusted to the bandwidth of one channel of the channel group corresponding to said only one cell 7, and the associated intermediate amplifier 11 is adjusted to a gain equal to a known and predetermined value, e.g. 10 dB;
- the output power of each channel of the channel group is measured, e.g. through a radio frequency detector placed at the output of the device 1;
- for each channel, the input power upstream of said input amplifier 3 is obtained from the output power and the gain values of the input amplifier 3, the intermediate amplifier 11 and the output amplifier 15.

The channels 17 outputted from the cells 7 are then supplied to the adder 13, which groups them again into a plurality of radio-television channels 14, which in turn are inputted to an output variable-gain amplifier 15 that further amplifies the channels 14 in order to output from the device the channels 16 amplified and equalized according to the following procedure:
- the gain of the input amplifier 3 is adjusted in a manner such that the channels 4 outputted by the input amplifier 3 have the highest signal level without generating any distortion in the signal itself;
- the gain of each cell 7 is adjusted in a manner such that the channels 17 outputted by the cell 7 have substantially the same signal level;
- the gain of the final amplifier 15 is adjusted in a manner such as to obtain, at the output of the final amplifier 15, channels 16 having the highest possible signal level as well as distortion and noise figure levels below a predetermined limit.

The features of the present invention, as well as the advantages thereof, are apparent from the above description.

A first advantage of the device and method according to the present invention is that a plurality of radio-television channels are amplified to the highest possible signal level without generating any distortion in the signal.

A second advantage of the device and method according to the present invention is that the device, which is very simple from a circuital viewpoint, can be easily implemented in a radio-television signal receiver.

The method and the device for equalizing a plurality of radio-television channels described herein by way of example may be subject to many possible variations without departing from the novelty spirit of the inventive idea; it is also clear that in the practical implementation of the invention the illustrated details may have different shapes or be replaced with other technically equivalent elements.

It can therefore be easily understood that the present invention is not limited to a method and a device for equalizing a plurality of radio-television channels, but may be subject to many modifications, improvements or replacements of equivalent parts and elements without departing from the inventive idea, as clearly specified in the following claims.

## Claims

1. A device (1) for equalizing a plurality of radio-television channels (2) comprising subdivision means (8) for subdividing said plurality of radio-television channels (2) into channel groups (10), each channel group (10) comprising one or more of said channels of said plurality of radio-television channels (2), so that each channel belongs to a single channel group (10), wherein said subdivision means (8) comprise a plurality of filtering and amplifying means (7) for filtering only those channels of said plurality of radio-television channels (2) which belong to a respective channel group (10) and for amplifying said channels of each channel group (10) in a homogenous manner, **characterised in that**
said filtering and amplifying means (7) are controlled by a controller (12) in a manner such that the channels (17) outputted by each of said filtering and amplifying means (7) have the same signal level; each of said filtering and amplifying means (7) comprises a variable-frequency and variable-bandwidth filter (9) and an intermediate variable-gain amplifier (11),
and wherein said device comprises
upstream of said plurality of filtering and amplifying means (7), a distribution matrix (5) for replicating said plurality of radio-television channels (2) at the inputs of said filtering and amplifying means (7) and,
upstream of said distribution matrix (5), an input variable-gain amplifier (3) for amplifying said plurality of radio-television channels (2),
downstream of said filtering and amplifying means (7), an adder (13) for adding up said channels (17) outputted by each of said filtering and amplifying means (7) and, downstream of said adder (13), an output variable-gain amplifier (15),
and wherein said device (1) is configured for:
- adjusting said input amplifier (3) and said output variable-gain amplifier (15) to respective maximum gain values;
- powering in rotation only one of said filtering and amplifying means (7);
- adjusting the variable-frequency and variable-bandwidth filter (9) of said only one filtering and amplifying means (7) to the bandwidth of one channel of the channel group (10) corresponding to said only one filtering and amplifying means (7), and adjusting the respective intermediate amplifier (11) to a known and predetermined gain value;
- measuring the output power of each channel of said channel group (10);
- for each channel, obtaining the input power upstream of said input amplifier (3) from said output power and the gain values of said input amplifier (3), said intermediate amplifier (11) and said output variable-gain amplifier (15);
- adjusting the gain of the input amplifier (3) in a manner such that the channels (4) outputted by said input amplifier (3) have the highest signal level without generating any distortion in the signal itself;
- adjusting the gain of each filtering and amplifying means (7) in a manner such that the channels (17) outputted by each of said filtering and amplifying means (7) have the same signal level;
- adjusting the gain of said output variable-gain amplifier (15) so as to obtain, at the output of said output variable-gain amplifier (15), channels (16) having the highest possible signal level as well as distortion and noise figure levels below a predetermined limit.

2. A device according to claim 1, wherein said plurality of radio-television channels (2) comprise a plurality of radio-television channels in the UHF band.

3. A device according to claim 1 or 2, wherein said plurality of radio-television channels (2) comprise a plurality of digital terrestrial radio-television channels.

4. A radio-television signal receiver comprising a device according to one or more of the preceding claims.

5. A method for equalizing a plurality of radio-television channels (2), comprising the following steps:
a) through subdivision means (8), subdividing said plurality of radio-television channels (2) into channel groups (10), each channel group (10) comprising one or more of said channels of said plurality of radio-television channels (2), so that each channel belongs to a single channel group (10);
b) through filtering and amplifying means (7) comprised in said subdivision means (8), filtering only those channels of said plurality of radio-television channels which belong to a respective channel group (10) and amplifying said channels of each channel group (10) in a homogenous manner, **characterised in that** said method further comprises the step of
c) controlling each of said filtering and amplifying means (7) through a controller (12) in a manner such that the channels (17) outputted by each of said filtering and amplifying means (7) have the same signal level;
- providing, upstream of said filtering and amplifying means (7), a distribution matrix (5) for replicating said plurality of radio-television channels (2) at the inputs of said filtering and amplifying means (7) and, upstream of said distribution matrix (5), an input variable-gain amplifier (3) for amplifying said plurality of radio-television channels (2);
- providing, downstream of said filtering and amplifying means (7), each of which comprises a variable-frequency and variable-bandwidth filter (9) and an intermediate variable-gain amplifier (11), an adder (13) for adding up said channels (17) outputted by each of said filtering and amplifying means (7);
- providing, downstream of said adder (13), an output variable-gain amplifier (15), wherein said step b) comprises the steps of:
- adjusting said input amplifier (3) and said output variable-gain amplifier (15) to respective maximum gain values;
- powering in rotation only one of said filtering and amplifying means (7);
- adjusting the variable-frequency and variable-bandwidth filter (9) of said only one filtering and amplifying means (7) to the bandwidth of one channel of the channel group (10) corresponding to said only one filtering and amplifying means (7), and adjusting the respective intermediate amplifier (11) to a known and predetermined gain value;
- measuring the output power of each channel of said channel group (10);
- for each channel, obtaining the input power upstream of said input amplifier (3) from said output power and the gain values of said input amplifier (3), said intermediate amplifier (11) and said output variable-gain amplifier (15);
and wherein said step c) comprises the steps of:
- adjusting the gain of the input amplifier (3) in a manner such that the channels (4) outputted by said input amplifier (3) have the highest signal level without generating any distortion in the signal itself;
- adjusting the gain of each filtering and amplifying means (7) in a manner such that the channels (17) outputted by each of said filtering and amplifying means (7) have the same signal level;
- adjusting the gain of said output variable-gain amplifier (15) so as to obtain, at the output of said output variable-gain amplifier (15), channels (16) having the highest possible signal level as well as distortion and noise figure levels below a predetermined limit.

6. A method according to claim 5, wherein said step a) is carried out in a manner such as to constitute groups of channels having similar signal levels, in particular channel groups (10) including adjacent channels.

7. A method according to claim 5 or 6, wherein said plurality of radio-television channels (2) comprise a plurality of radio-television channels in the UHF band.

8. A method according to claim 7, wherein said plurality of radio-television channels (2) comprise a plurality of digital terrestrial radio-television channels.

## Patentansprüche

1. Gerät (1) zum Ausgleichen einer Mehrzahl von Funkfernsehkanälen (2), umfassend Unterteilungsmittel (8) zum Unterteilen der Mehrzahl von Funkfernsehkanälen (2) in Kanalgruppen (10), wobei jede Kanalgruppe (10) einen oder mehrere der Kanäle der Mehrzahl von Funkfernsehkanälen (2) umfasst, sodass jeder Kanal zu einer einzigen Kanalgruppe (10) gehört, wobei die Unterteilungsmittel (8) eine Mehrzahl von Filter- und Verstärkermitteln (7) zum Filtern nur derjenigen Kanäle der Mehrzahl von Funkfernsehkanälen (2), die zu einer entsprechenden Kanalgruppe (10) gehören, und zum Verstärken der Kanäle jeder Kanalgruppe (10) in einer homogenen Weise umfasst,
**dadurch gekennzeichnet, dass**
die Filter- und Verstärkermittel (7) durch einen Kontroller (12) in einer Weise kontrolliert werden, dass die Kanäle (17), die von jedem der Filter- und Verstärkermittel (7) ausgegeben werden, denselben Signalpegel aufweisen, wobei jedes der Filter- und Verstärkermittel (7) einen Filter (9) variabler Frequenz und variabler Bandbreite und einen Zwischenverstärker (11) variabler Verstärkung umfasst,
und wobei das Gerät umfasst
vorgelagert vor der Mehrzahl von Filter- und Verstärkermitteln (7), eine Verteilungsmatrix (5) zum Replizieren der Mehrzahl von Funkfernsehkanälen (2) an den Eingängen der Filter- und Verstärkermittel (7) und,
vorgelagert vor der Verteilungsmatrix (5), einen Eingangsverstärker (3) variabler Verstärkung zum Verstärken der Mehrzahl von Funkfernsehkanälen (2),
nachgelagert nach den Filter- und Verstärkermitteln (7), einen Addierer (13) zum Zusammenaddieren der Kanäle (17), die von jedem der Filter- und Verstärkermittel (7) ausgegeben werden und,
nachgelagert nach dem Addierer (13), einen Ausgangsverstärker (15) variabler Verstärkung,
und wobei das Gerät (1) ausgebildet ist zum:
- Einstellen des Eingangsverstärkers (3) und des Ausgangsverstärkers (15) variabler Verstärkung auf entsprechend maximale Verstärkungswerte;
- abwechselnden Einschalten jeweils nur eines der Filter- und Verstärkermittel (7);
- Einstellen des Filters (9) variabler Frequenz und variabler Bandbreite des nur einen Filter- und Verstärkermittels (7) auf die Bandbreite eines Kanals der Kanalgruppe (10), der zu dem nur einen Filter- und Verstärkermittel (7) korrespondiert, und Einstellen des entsprechenden Zwischenverstärkers (11) auf einen bekannten und vorbestimmten Verstärkungswert;
- Messen der Ausgangsleistung jedes Kanals der Kanalgruppe (10);
- für jeden Kanal, Erhalten der vor dem Eingangsverstärker (3) vorgelagerten Eingangsleistung aus der Ausgangsleistung und den Verstärkungswerten des Eingangsverstärkers (3), des Zwischenverstärkers (11) und des Ausgangsverstärkers (15) variabler Verstärkung;
- Einstellen der Verstärkung des Eingangsverstärkers (3) in einer Weise, dass die Kanäle (4), die durch den Eingangsverstärker (3) ausgegeben werden, den höchsten Signalpegel aufweisen, ohne dass eine Verzerrung in dem Signal selbst erzeugt wird;
- Einstellen der Verstärkung jedes Filter- und Verstärkermittels (7) in einer Weise, dass die Kanäle (17), die durch jedes der Filter- und Verstärkermittel (7) ausgegeben werden, denselben Signalpegel aufweisen;
- Einstellen der Verstärkung des Ausgangsverstärkers (15) variabler Verstärkung, um, an dem Ausgang des Ausgangsverstärkers (15) variabler Verstärkung, Kanäle (16) zu erhalten, die den höchstmöglichen Signalpegel sowie Verzerrungs- und Rauschmaßwerte unterhalb eines vorbestimmten Grenzwerts aufweisen.

2. Gerät nach Anspruch 1, wobei die Mehrzahl von Funkfernsehkanälen (2) eine Mehrzahl von Funkfernsehkanälen in dem UHF-Band umfasst.

3. Gerät nach Anspruch 1 oder 2, wobei die Mehrzahl von Funkfernsehkanälen (2) eine Mehrzahl von digitalen terrestrischen Funkfernsehkanälen umfasst.

4. Funkfernsehsignalempfänger, umfassend ein Gerät nach einem oder mehreren der vorangegangenen Ansprüche.

5. Verfahren zum Ausgleichen einer Mehrzahl von Funkfernsehkanälen (2), umfassend die folgenden Schritte:
a) durch Unterteilungsmittel (8), Unterteilen der Mehrzahl von Funkfernsehkanälen (2) in Kanalgruppen (10), wobei jede Kanalgruppe (10) einen oder mehrere der Kanäle der Mehrzahl von Funkfernsehkanälen (2) umfasst, sodass jeder Kanal zu einer einzigen Kanalgruppe (10) gehört;
b) durch Filter- und Verstärkermittel (7), die in den Unterteilungsmitteln (8) enthalten sind, Filtern nur derjenigen Kanäle der Mehrzahl von Funkfernsehkanälen, die zu einer entsprechenden Kanalgruppe (10) gehören, und Verstärken der Kanäle jeder Kanalgruppe (10) in einer homogenen Weise,
**dadurch gekennzeichnet, dass** das Verfahren des Weiteren den Schritt umfasst
c) Kontrollieren jedes der Filter- und Verstärkermittel (7) durch einen Kontroller (12) in einer Weise, dass die Kanäle (17), die von jedem der Filter- und Verstärkermittel (7) ausgegeben werden, denselben Signalpegel aufweisen;
- Bereitstellen, vorgelagert vor den Filter- und Verstärkermitteln (7), einer Verteilungsmatrix (5) zum Replizieren der Mehrzahl von Funkfernsehkanälen (2) an den Eingängen der Filter- und Verstärkermittel (7) und, vorgelagert vor der Verteilungsmatrix (5), eines Eingangsverstärkers (3) variabler Verstärkung zum Verstärken der Mehrzahl von Funkfernsehkanälen (2);
- Bereitstellen, nachgelagert nach den Filter- und Verstärkermitteln (7), von denen jedes einen Filter (9) variabler Frequenz und variabler Bandbreite und einen Zwischenverstärker (11) variabler Verstärkung umfasst, eines Addierers (13) zum Zusammenaddieren der Kanäle (17), die von jedem der Filter- und Verstärkermittel (7) ausgegebenen werden;
- Bereitstellen, nachgelagert nach dem Addierer (13), eines Ausgangsverstärkers (15) variabler Verstärkung,
wobei der Schritt b) die Schritte umfasst:
- Einstellen des Eingangsverstärkers (3) und des Ausgangsverstärkers (15) variabler Verstärkung auf entsprechend maximale Verstärkungswerte;
- abwechselndes Einschalten jeweils nur eines der Filter- und Verstärkermittel (7);
- Einstellen des Filters (9) variabler Frequenz und variabler Bandbreite des nur einen Filter- und Verstärkermittels (7) auf die Bandbreite eines Kanals der Kanalgruppe (10), der zu dem nur einen Filter- und Verstärkermittel (7) korrespondiert, und Einstellen des entsprechenden Zwischenverstärkers (11) auf einen bekannten und vorbestimmten Verstärkungswert;
- Messen der Ausgangsleistung jedes Kanals der Kanalgruppe (10);
- für jeden Kanal, Erhalten der vor dem Eingangsverstärker (3) vorgelagerten Eingangsleistung aus der Ausgangsleistung und den Verstärkungswerten des Eingangsverstärkers (3), des Zwischenverstärkers (11) und des Ausgangsverstärkers (15) variabler Verstärkung;
und wobei der Schritt c) die Schritte umfasst:
- Einstellen der Verstärkung des Eingangsverstärkers (3) in einer Weise, dass die Kanäle (4), die durch den Eingangsverstärker (3) ausgegeben werden, den höchsten Signalpegel aufweisen, ohne dass eine Verzerrung in dem Signal selbst erzeugt wird;
- Einstellen der Verstärkung jedes Filter- und Verstärkermittels (7) in einer Weise, dass die Kanäle (17), die durch jedes der Filter- und Verstärkermittel (7) ausgegeben werden, denselben Signalpegel aufweisen;
- Einstellen der Verstärkung des Ausgangsverstärkers (15) variabler Verstärkung, um, an dem Ausgang des Ausgangsverstärkers (15) variabler Verstärkung, Kanäle (16) zu erhalten, die den höchstmöglichen Signalpegel sowie Verzerrungs- und Rauschmaßwerte unterhalb eines vorbestimmten Grenzwerts aufweisen.

6. Verfahren nach Anspruch 5, wobei der Schritt a) in einer Weise ausgeführt wird, um Gruppen von Kanälen, die ähnliche Signalpegel aufweisen, zu begründen, insbesondere Kanalgruppen (10), die benachbarte Kanäle beinhalten.

7. Verfahren nach Anspruch 5 oder 6, wobei die Mehrzahl von Funkfernsehkanälen (2) eine Mehrzahl von Funkfernsehkanälen in dem UHF-Band umfasst.

8. Verfahren nach Anspruch 7, wobei die Mehrzahl von Funkfernsehkanälen (2) eine Mehrzahl von digitalen terrestrischen Funkfernsehkanälen umfasst.

## Revendications

1. Dispositif (1) d'égalisation d'une pluralité de canaux de radiotélévision (2) comprenant des moyens de subdivision (8) servant à subdiviser ladite pluralité de canaux de radiotélévision (2) en groupes de canaux (10), chaque groupe de canaux (10) comprenant un ou plusieurs desdits canaux de ladite pluralité de canaux de radiotélévision (2), de sorte que chaque canal appartient à un seul groupe de canaux (10), dans lequel lesdits moyens de subdivision (8) comprennent une pluralité de moyens filtrage et d'amplification (7) servant à filtrer uniquement les canaux de ladite pluralité de canaux de radiotélévision (2) qui appartiennent à un groupe de canaux (10) respectif et à amplifier lesdits canaux de chaque groupe de canaux (10) de manière homogène,
**caractérisé en ce que**
lesdits moyens de filtrage et d'amplification (7) sont commandés par un contrôleur (12) de telle manière que les canaux (17) en sortie de chacun desdits moyens de filtrage et d'amplification (7) présentenet le même niveau de signal ; chacun desdits moyens de filtrage et d'amplification (7) comprennent un filtre (9) à fréquence variable et à largeur de bande variable et un amplificateur intermédiaire (11) à gain variable,
et ledit dispositif comprenant
en amont de ladite pluralité de moyens de filtrage et d'amplification (7) une matrice de distribution (5) servant à reproduire ladite pluralité de canaux de radiotélévision (2) au niveau des entrées desdits moyens de filtrage et d'amplification (7) et,
en amont de ladite matrice de distribution (5) un amplificateur d'entrée à gain variable (3) servant à amplifier ladite pluralité de canaux de radiotélévision (2),
en aval desdits moyens de filtrage et d'amplification (7) un additionneur (13) servant à additionner lesdits canaux (17) en sortie de chacun desdits moyens de filtrage et d'amplification (7) et,
en aval dudit additionneur (13), un amplificateur de sortie à gain variable (15),
et ledit dispositif (1) étant configuré pour :
- ajuster ledit amplificateur d'entrée (3) et ledit amplificateur de sortie à gain variable (15) à des valeurs de gain maximales respectives ;
- mettre en rotation un seul desdits moyens de filtrage et d'amplification (7) ;
- ajuster le filtre à fréquence variable et à largeur de bande variable (9) dudit seul moyen de filtrage et d'amplification (7) à la bande passante d'un canal du groupe de canaux (10) correspondant audit seul moyen de filtrage et d'amplification (7) et ajuster l'amplificateur intermédiaire (11) respectif à une valeur de gain prédéterminée et connue ;
- mesurer la puissance de sortie de chaque canal dudit groupe de canaux (10) ;
- pour chaque canal, obtenir la puissance d'entrée en amont dudit amplificateur d'entrée (3) à partir de ladite puissance de sortie et des valeurs de gain dudit amplificateur d'entrée (3), dudit amplificateur intermédiaire (11) et dudit amplificateur de sortie à gain variable (15) ;
- ajuster le gain de l'amplificateur d'entrée (3) de telle manière que les canaux (4) en sortie dudit amplificateur d'entrée (3) présentent le niveau de signal le plus élevé sans générer de distorsion dans le signal lui-même ;
- ajuster le gain de chacun des moyens de filtrage et d'amplification (7) de telle manière que les canaux (17) en sortie de chacun desdits moyens de filtrage et d'amplification (7) présentent le même niveau de signal ;
- ajuster le gain dudit amplificateur de sortie à gain variable (15) de manière à obtenir, en sortie dudit amplificateur de sortie à gain variable (15), des canaux (16) présentant le niveau de signal le plus élevé possible ainsi que des niveaux de distorsion et de bruit inférieurs à une limite prédéterminée.

2. Dispositif selon la revendication 1, dans lequel ladite pluralité de canaux de radiotélévision (2) comprennent une pluralité de canaux de radiotélévision dans la bande UHF.

3. Dispositif selon la revendication 1 ou 2, dans lequel ladite pluralité de canaux de radiotélévision (2) comprennent une pluralité de chaînes de radiotélévision numériques terrestres.

4. Récepteur de signaux de radiotélévision comprenant un dispositif selon l'une ou plusieurs des revendications précédentes.

5. Procédé d'égalisation d'une pluralité de canaux de radiotélévision (2), comprenant les étapes suivantes consistant à :
a) par le biais de moyens de subdivision (8), subdiviser ladite pluralité de canaux de radiotélévision (2) en groupes de canaux (10), chaque groupe de canaux (10) comprenant un ou plusieurs desdits canaux de ladite pluralité de canaux de radiotélévision (2) de sorte que chaque canal appartient à un seul groupe de canaux (10) ;
b) par le biais de moyens de filtrage et d'amplification (7) compris dans lesdits moyens de subdivision (8), filtrer uniquement les canaux de ladite pluralité de canaux de radiotélévision qui appartiennent à un groupe de canaux (10) respectif et amplifier lesdits canaux de chaque groupe de canaux (10) de manière homogène, **caractérisé en ce que** ledit procédé comprend en outre l'étape consistant à
c) commander chacun desdits moyens de filtrage et d'amplification (7) par le biais d'un contrôleur (12) de telle manière que les canaux (7) en sortie de chacun desdits moyens de filtrage et d'amplification présentent le même niveau de signal ;
- produire, en amont desdits moyens de filtrage et d'amplification (7), une matrice de distribution (5) servant à reproduire ladite pluralité de canaux de radiotélévision (2) au niveau des entrées desdits moyens de filtrage et d'amplification (7) et, en amont de ladite matrice de distribution (5), un amplificateur d'entrée à gain variable (3) servant à amplifier ladite pluralité de canaux de radiotélévision (2) ;
- produire, en aval desdits moyens de filtrage et d'amplification (7), qui comprennent chacun un filtre (9) à fréquence variable et à largeur de bande variable et un amplificateur intermédiaire (11) à gain variable, un additionneur (13) servant à additionner lesdits canaux (17) en sortie de chacun desdits moyens de filtrage et d'amplification (7) ;
- produire, en aval dudit additionneur (13), un amplificateur de sortie à gain variable (15), ladite étape b) comprenant les étapes consistant à :
- ajuster ledit amplificateur d'entrée (3) et ledit amplificateur de sortie à gain variable (15) à des valeurs de gain maximales respectives ;
- mettre en rotation un seul desdits moyens de filtrage et d'amplification (7) ;
- ajuster le filtre à fréquence variable et à largeur de bande variable (9) dudit seul moyen de filtrage et d'amplification (7) à la bande passante d'un canal du groupe de canaux (10) correspondant audit seul moyen de filtrage et d'amplification (7) et ajuster l'amplificateur intermédiaire (11) respectif à une valeur de gain prédéterminée et connue ;
- mesurer la puissance de sortie de chaque canal dudit groupe de canaux (10) ;
- pour chaque canal, obtenir la puissance d'entrée en amont dudit amplificateur d'entrée (3) à partir de ladite puissance de sortie et des valeurs de gain dudit amplificateur d'entrée (3), dudit amplificateur intermédiaire (11) et dudit amplificateur de sortie à gain variable (15) ;
et ladite étape c) comprenant les étapes consistant à :
- ajuster le gain de l'amplificateur d'entrée (3) de telle manière que les canaux (4) en sortie dudit amplificateur d'entrée (3) présentent le niveau de signal le plus élevé sans générer de distorsion dans le signal lui-même ;
- ajuster le gain de chacun des moyens de filtrage et d'amplification (7) de telle manière que les canaux (17) en sortie de chacun desdits moyens de filtrage et d'amplification (7) présentent le même niveau de signal ;
- ajuster le gain dudit amplificateur de sortie à gain variable (15) de manière à obtenir, en sortie dudit amplificateur de sortie à gain variable (15), des canaux (16) présentant le niveau de signal le plus élevé possible ainsi que des niveaux de distorsion et de bruit inférieurs à une limite prédéterminée.

6. Procédé selon la revendication 5, dans lequel ladite étape a) est réalisée de manière à constituer des groupes de canaux présentant des niveaux de signal similaires, en particulier des groupes de canaux (10) incluant des canaux adjacents.

7. Procédé selon la revendication 5 ou 6, dans lequel ladite pluralité de canaux de radiotélévision (2) comprennent une pluralité de canaux de radiotélévision dans la bande UHF.

8. Procédé selon la revendication 7, dans lequel ladite pluralité de canaux de radiotélévision (2) comprennent une pluralité de chaînes de radiotélévision numériques terrestres.
